(19) **Europäisches Patentamt**
**European Patent Office**
**Office européen des brevets**

(11) Veröffentlichungsnummer: **0 127 792**
**B1**

(12) **EUROPÄISCHE PATENTSCHRIFT**

(45) Veröffentlichungstag der Patentschrift: **28.09.88**

(51) Int. Cl.⁴: **H 03 G 3/20,** H 03 G 7/00

(21) Anmeldenummer: **84105197.2**

(22) Anmeldetag: **08.05.84**

(54) **Empfangsgerät.**

(30) Priorität: **01.06.83 DE 3319786**

(43) Veröffentlichungstag der Anmeldung:
**12.12.84 Patentblatt 84/50**

(45) Bekanntmachung des Hinweises auf die
Patenterteilung:
**28.09.88 Patentblatt 88/39**

(84) Benannte Vertragsstaaten:
**AT BE CH DE FR GB IT LI LU NL SE**

(56) Entgegenhaltungen:
**US-A-2 112 279**

**NTG-NTF 1983, Hörrundfunk 6, November
1982, Seiten 151-158, Mannheim, DE; I.
PORGES u.a.: "Ein kompatibles
Kompandierungsverfahren für FM-Rundfunk
und dessen Schaltungstechnische
Realisierungen"**

(73) Patentinhaber: **TELEFUNKEN Fernseh und
Rundfunk GmbH
Göttinger Chaussee 76
D-3000 Hannover 91 (DE)**

(72) Erfinder: **Schröder, Ernst, Dipl.-Ing.
Pinkenburger Strasse 25D
D-3000 Hannover 51 (DE)**
Erfinder: **Wiedenroth, Bernd, Dipl.-Ing.
An der Mühle 1
D-3005 Hemmingen (DE)**

(74) Vertreter: **Einsel, Robert, Dipl.-Ing.
TELEFUNKEN Fernseh und Rundfunk GmbH
Göttinger Chaussee 76
D-3000 Hannover 91 (DE)**

Courier Press, Leamington Spa, England.

**Beschreibung**

Die Erfindung betrifft ein Empfangsgerät für den Empfang von Rundfunk-Sendungen gemäß dem Oberbegriff des Patentanspruchs 1.

In NTG-NTF '83, Hörrundfunk 6, Mannheim November 1982, Seite 150—158 ist ein Empfangsgerät für UKW-FM-Sendungen beschrieben, das zur Reduzierung von Störgeräuschen einer Übertragungsstrecke mit einem Dynamik-Expander ausgerüstet ist. Die heute üblichen UKW-FM-Empfangsgeräte verwenden einen Zwischenfrequenzverstärker, im weiteren ZF-Verstärker genannt, mit extrem guter Begrenzung. Schon bei kleinsten Antenneneingangsspannungen ergibt sich ein konstaner Ausgangspegel. Die Anschaltung eines Dynamik-Expanderteils eines Kompandersystems ist problemlos, da eine kostante Pegeleinrichtung erfolgen kann.

Bei sehr kleiner Antenneneingangsspannung wird aber das Rauschen so groß, daß der Dynamik-Expander vom Rauschpegel gesteuert wird und das Rauschen noch verstärkt. Deshalb wird zweckmäßig der Dynamik-Expander bei geringen Antenneneingangsspannungen abgeschaltet. Gleichzeitig kann der Empfänger durch eine Stummabstimmungsschaltung, eine Mutingschaltung, abgeschaltet werden.

In einem Autoradio kann eine Mutingschaltung jedoch nicht eingesetzt werden, da die Empfangsverhältnisse in dem sich bewegenden Fahrzeug teilweise sehr schlecht und schnell wechselnd sind. Eine Mutingschaltung würde sehr häufig ansprechen, und sich als Ein/Ausschaltung für den Hörer bemerkbar machen. Üblicherweise werden daher im einem UKW-FM-Empfänger für Kraftfahrzeuge ZF-Verstärker mit Ratio-Detektoren verwendet, die erst zu höheren Antenneneingangsspannungen hin ihre volle Begrenzerwirkung erreichen. Bei geringer Antenneneingangsspannung sinkt die NF-Ausgangsspannung ab. Das Aufrauschen erreicht nicht so stark störende Werte. Üblich ist die Auslegung auf etwa 30 dB Absenkung des NF-Ausgangssignals bei kleinen Antenneneingangsspannungen.

Schaltet man einen Dynamik-Expander hinzu, z.B. wie er in NTG-NTF '83, Hörrundfunk 6, November 1982, Seite 150—158 beschrieben ist, so zeigt sich:

1. bei hohen Antenneneingangsspannungen ist die Wirkung wie erwartet,

2. bei sehr kleinen Antenneneingangsspannungen wird das Aufrauschen um 10 dB niedriger, allerdings wird auch die Absenkung des Rest-NF-Signals um 10 dB größer.

Bei sehr kleinen Antenneneingangsspannungen hat der Benutzer dann das Gefühl, daß sein Radio abgeschaltet ist. Dies wird als störend empfunden.

Aufgabe der Erfindung ist es, eine Empfängerschaltung für den Empfang von Rundfunksendungen mit einem Dynamik-Expander für den Einsatz bei schwankenden Antenneneingangsspannungen zu schaffen.

Diese Aufgabe wird bei einer Schaltung nach dem Oberbegriff des Anspruchs 1 und durch die im Kennzeichen angegebenen Merkmale gelöst.

In der US—A—2 122 279 wird ein Empfänger für amplifidumodulierte Signale beschrieben, bei dem eine Verstärkungsregelung und/oder eine Dynamikregelung erfolgt. Diese Regelungen erfolgen jedoch unabhängig von einander.

Weiterbildungen und vorteilhafte Ausführungsformen sind in den Unteransprüchen angegeben.

Die Erfindung wird nun an Hand eines Ausführungsbeispiels, das in den Zeichnungen dargestellt ist, erläutert.

Darin zeigen:

Fig. 1 die Eingangskennlinie eines bekannten Heim-UKW-FM-Empfängers,

Fig. 2 die Eingangskennlinie eines bekannten Auto-UKW-FM-Empfängers,

Fig. 3 eine Expander-Kennlinie und

Fig. 4 die Eingangskennlinie eines erfindungsgemäßen UKW-FM-Empfängers mit und ohne Dynamik-Expander.

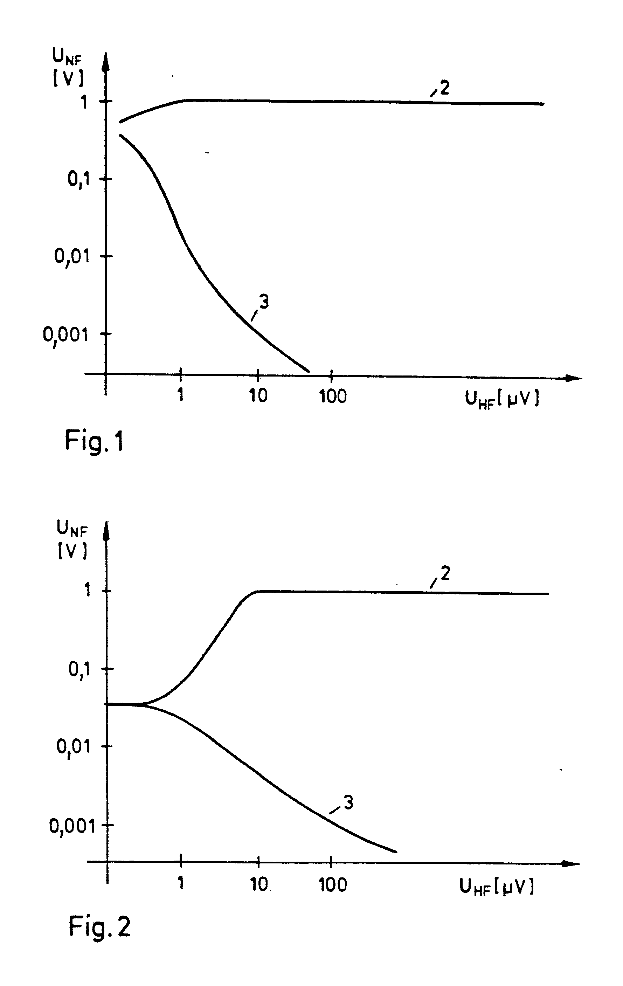

Fig. 1 zeigt die Eingangskennlinie eines bekannten UKW-FM-Empfängers. Auf der Abzisse sind die Antenneneingangsspannung $U_{HF}$, auf der Ordinate die NF-Ausgangsspannung $U_{NF}$ aufgetragen. Die obere Kennlinie 2 zeigt die NF-Ausgangsspannung $U_{NF}$ bei einem Modulationssignal mit der Frequenz 1 kHz und einem FM-Modulationshub von 40 kHz. Die untere Kennlinie 3 zeigt die NF-Ausgangsspannung bei einem unmodulierten Signal. Der Fig. 1 ist zu entnehmen, daß bei einer Antenneneingangsspannung $U_{HF}$ größer als 1 µV das NF-Ausgangssignal $U_{NF}$ von der Antenneneingangsspannung $U_{HF}$ unabhängig ist. Unterhalb von 1 µV Antenneneingangsspannung $U_{HF}$ sinkt die NF-Ausgangsspannung $U_{NF}$ geringfügig ab. Die Störspannung bei unmoduliertem Signal steigt steil an, das Signal/Rauschverhältnis wird zu kleinen Antenneneingangsspannungen $U_{HF}$ hin immer schlechter.

Fig. 2 zeigt die Eingangskennlinie eines bekannten Auto-UKW-FM-Empfängers. Die Begrenzung des NF-Ausgangssignals $U_{NF}$ setzt hier erst bei einer Antenneneingangsspannung $U_{HF}$ von mehrmals ca. 10 µV ein. Im Vergleich zu Fig. 1 ist der Rauschpegel 3 zu sehr geringen Antenneneingangssignalen $U_{HF}$ um ca. 30 dB geringer.

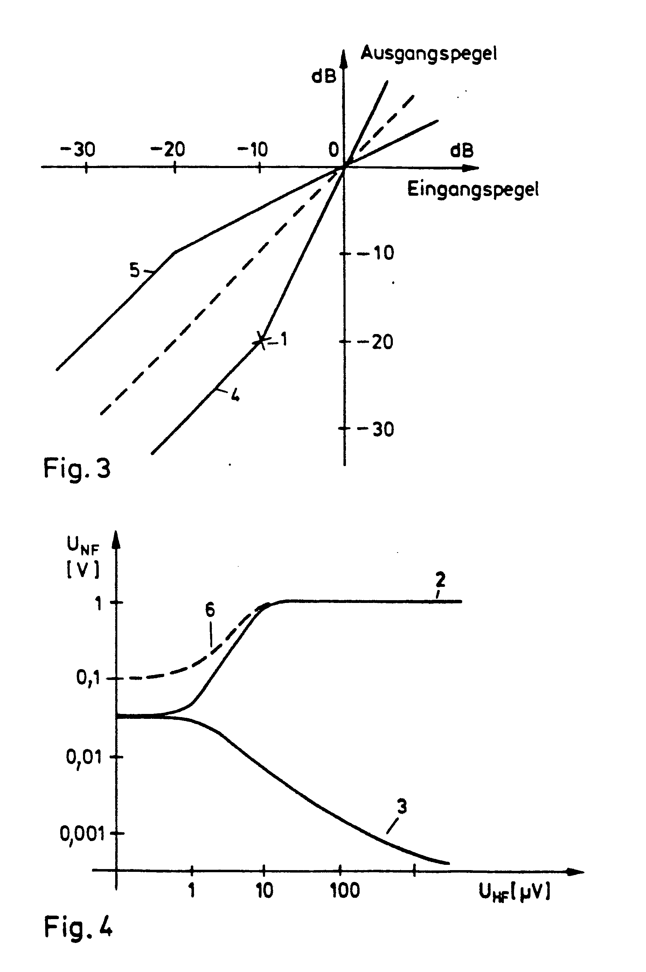

Fig. 3 zeigt die Kennlinie 4 eines Dynamik-Expanders mit einer Steigung von 2:1, wie sie in der DE—A—24 03 799, Fig. 3 beschrieben ist. Die Kennlinie 5 zeigt die Kennlinie des zugehörigen Kompressors. Im bereich der Kennlinie 4 mit der Steigung von 2:1 wirkt das Absinken des Eingangssignals auf den Dynamik-Expander wie ein Pegelfehler. Die maximale Expansion beträgt 10 dB. In dem Bereich, in dem die Kennlinie eine Steigung von 1:1 aufweist — unterhalb eines Knickpunktes 1 — wirkt der Expander wie ein Dämpfungsglied mit −10 dB. Der Expander expandiert nicht mehr und es wird das in komprimierter Form vorliegende Eingangssignal weiterverarbeitet. Dieses hat den Vorteil, daß im Bereich mit kleinen Antenneneingangssignalen $U_{HF}$ die Verständlichkeit durch die reduzierte Dynamik des komprimierten Signals größer ist als bei einem unkomprimiert empfangenen Signals.

Fig. 4 zeigt die Eingangskennlinie eines erfindungsgemäßen UKW-FM-Empfängers mit und ohne Dynamik-Expander. Die durchgezogenen Kennlinien 2 und 3, die den Betrieb des UKW-FM-Empfängers ohne Dynamik-Expander darstellen, zeigen den gleichen Verlauf wie in Fig. 2.

Wird ein Dynamik-Expander eingeschaltet, dessen Kennlinie in Fig. 3 aufgezeichnet ist, so wird die ZF-Verstärkung des UKW-FM-Empfängers so geändert, daß sich eine Charakteristik 6 einstellt, die gestrichelt in Fig. 4 eingezeichnet ist. Der bei Heim-UKW-FM-Empfänger verwendete ZF-Verstärker mit Demodulator wird mit einem Regelverstärker aufgebaut, der eine Eingangs/Ausgangskennlinie ähnlich der eines Ratio-Detektors erzeugt. Gleichzeitig mit dem Zuschalten des Dynamik-Expanders wird die Verstärkung dieses Regelverstärkers so geändert, daß die Kennlinie für niedrige Antenneneingangsspannungen $U_{HF}$ um +10 dB verschoben wird. Die in Fig. 3 aufgezeigte Dämpfung des Expanders von 10 dB wird somit aufgehoben. Die Umschaltung des ZF-Verstärkers geschieht vorteilhaft mit dem Ein-Aus-Schalter des Dynamik-Expanders.

**Patentansprüche**

1. Empfangsgerät für den Empfang von Rundfunksendungen, insbesondere für Fahrzeuge, mit einem Zwischenfrequenzverstärker und einem Demodulator, deren Eingangs/Ausgangskennlinie für schwache Antenneneingangssignale ausgelegt ist, mit einem schaltbaren Dynamik-Expander zum wahlweisen Empfange dynamikkomprimierter Signale, dadurch gekennzeichnet, daß beim Einschalten des Dynamik-Expanders die Eingangs/Ausgangskennlinie für niedrigere Antenneneingangsspannung ($U_{HF}$) zu höheren Werten einer NF-Ausgangsspannung ($U_{NF}$) verschoben wird.

2. Empfangsgerät nach Anspruch 1, dadurch gekennzeichnet, daß die Eingangs/Ausgangskennlinie (Fig. 4) un den gleichen Betrag angehoben wird, um den sie der Dynamik-Expander reduziert.

3. Empfangsgerät nach Anspruch 1 oder 2, dadurch gekennzeichnet, daß die Verstärkung des Zwischenfrequenzverstärkers erhöht wird, wenn der Dynamik-Expander eingeschaltet wird.

4. Empfangsgerät nach Anspruch 1, dadurch gekennzeichnet, daß der Zwischenfrequenzverstärker einen Regelverstärker enthält.

5. Empfangsgerät nach Anspruch 1, dadurch gekennzeichnet, daß das Ausgangssignal des Zwischenfrequenzverstärkers und des Demodulators zu höheren Werten der Antenneneingangsspannung ($U_{HF}$) hin begrenzt wird.

**Revendications**

1. Appareil récepteur pour la réception d'émissions de radiodiffusion, notamment pour des véhicules, comportant un amplificateur à fréquence intermédiaire et un démodulateur, dont la courbe caractéristique d'entrée/sortie est conçue pour de faibles signaux d'entrée d'antenne, et un expanseur commutable pour la réception au choix de signaux ayant subi une compression de dynamique, caractérisé par le fait que lors du branchement de l'expanseur, la courbe caractéristique d'entrée/sortie est décalée, pour une plus faible tension d'entrée d'antenne ($U_{FH}$), vers des valeurs supérieures d'une tension de sortie à basse fréquence ($U_{NF}$).

2. Appareil récepteur suivant la revendication 1, caractérisé par le fait que la courbe caractéristique d'entrée/sortie (figure 4) est accrue de la même valeur que celle dont l'expanseur la réduit.

3. Appareil récepteur suivant la revendication 1 ou 2, caractérisé par le fait que l'amplification de l'amplificateur à fréquence intermédiaire est accrue lorsque l'expanseur est branché.

4. Appareil récepteur suivant la revendication 1, caractérisé par le fait que l'amplificateur de fréquence intermédiaire contient un amplificateur de réglage.

5. Appareil récepteur suivant la revendication 1, caractérisé par le fait que le signal de sortie de l'amplificateur à fréquence intermédiaire du démodulateur est limité en direction des valeurs supérieures de la tension d'entrée d'antenne ($U_{FH}$).

**Claims**

1. A receiving set for the reception of radio broadcasts, particularly for vehicles, having an intermediate-frequency amplifier and a demodulator, the input/output characteristic of which is designed for weak aerial input signals, with a controllable dynamic expander for the selective reception of volume-compressed signals, characterised in that when the dynamic expander is switched on, the input/output characteristic for a relatively low aerial input voltage ($U_{HF}$) is shifted towards higher values of an a.f. output voltage ($U_{NF}$).

2. A receiving set according to Claim 1, characterised in that the input/output characteristic (Figure 4) is raised by the same amount as that by which the dynamic expander reduces it.

3. A receiving set according to Claim 1 or 2, characterised in that the gain of the intermediate-frequency amplifier is increased if the dynamic expander is switched on.

4. A receiving set according to Claim 1, characterised in that the intermediate-frequency amplifier contains an automatic gain control amplifier.

5. A receiving set according to Claim 1, characterised in that the output signal of the intermediate-frequency amplifier and of the demodulator is limited towards higher values of the aerial input voltage ($U_{HF}$).

Fig.1

Fig.2

1

Fig. 3

Fig. 4